# EUROPEAN PATENT APPLICATION

(11) **EP 1 513 205 A2**
(43) Date of publication of application: **09.03.2005**
(21) Application number: 04020762.3
(22) Date of filing: 01.09.2004
(51) Int. Cl.: H01L 51/20

(54) **Light emitting device**

(30) Priority: 02.09.2003 JP 2003310293
(71) Applicant: Kabushiki Kaisha Toyota Jidoshokki, Kariya-shi, Aichi-ken (JP)
(72) Inventor: Utsumi, Tetsuya, deceased (JP)
(74) Representative: Leson, Thomas Johannes Alois, Dipl.-Ing.

(57) **Abstract**

A light emitting device has an electroluminescence device, an optical resonant structure and a fluorescent layer disposed over a substrate. The substrate has an incident surface and a light emitting surface opposite to the incident surface. The electroluminescence device is formed on the incident surface side of the substrate, for emitting light having a peak at a wavelength of no more than 490 nm. The optical resonant structure is formed on the incident surface side of the substrate side, for enhancing light having a resonant wavelength among the light emitted from the electroluminescent device. The fluorescent layer is formed on the light emitting surface side of the substrate, for converting the light emitted from the substrate into white light.

## Description

The present invention relates to a light emitting device,and in particular a light emitting device using an electroluminescence (EL) device as a light source.

A liquid crystal display device which uses an electroluminescence (EL) panel for backlighting the display is conventionally known. The EL panel includes an electroluminescence device formed from the lamination of an anode, an electroluminescence layer (EL layer) and a reflective cathode in this order over a substrate. The anode is formed from a material such as indium-tin oxide (ITO) having translucency. The light is emitted from the substrate side when the power is supplied to the EL device. In order to efficiently use the light emitted from the EL device, it is necessary for the light rays which entered into the substrate from the EL device to exit efficiently from the side (light emitting surface) opposite to the surface that faces the EL device. However, since the light rays emitted from the EL device propagate in various directions, the angle from which light is incident on the substrate can also vary. Accordingly, there is a substantial amount of light rays that are emitted from a side surface of the substrate, either directly without exiting from the light emitting surface or after being subjected to total reflection on the light emitting surface and then guided within the substrate. A substantial portion of the light rays emitted from the EL layer are therefore wasted in a conventional EL panel.

There is a display device which displays desired colors from white light emitted from an EL layer by means of a three-colored color filter of red (R) , green (G) and blue (B) , in the case of performing a full color mode display.

It was necessary in a conventional white-light emitting device to use different materials corresponding to three elementary colors red (R), green (G) and blue (B) or corresponding to complementary colors such as blue/yellow or blue lime/orange for the light emitting materials. Accordingly, the conventional light emitting device had a disadvantage in that the color balance could readily change through deterioration with time. In order to solve this problem, Japanese Laid-Open Patent Publication 2001-284049 discloses a light emitting device formed with a light converting film comprising an ortho-metalated complex, a transparent electrode, an organic light emitting layer and an opposing electrode over a translucent substrate. The Japanese Laid-Open Patent Publication 2001-284049 discloses a green light emitting device, a red light emitting device and a white light emitting device for the light emitting device. The publication further discloses that an organic light emitting device having a optical micro resonator (microcavity) can also be used.

When a microcavity is adopted, a light having a specific wavelength can be enhanced as well as the direction of the light having the wavelength can be improved. The direction of the light accommodates the thickness of the microcavity. Light having such directivity efficiently exits from the light emitting surface since the light which is reflected at the interface with the substrate or reflected within the substrate can be reduced.

However, it is hard to improve the light extraction efficiency in the structures disclosed in the publication when constituting a white light emitting device by using a combination of the microcavity and the color converting film.

That is, the light which has been enhanced and provided with directivity at the microcavity is color converted before passing through the substrate in the structures disclosed in the publication. The directivity degrades because the scattering of the light is inevitable during color conversion. As a result, the light extraction efficiency decreases compared to the case where light conversion is not performed.

The present invention has been devised in view of the above described problems. An object of the invention is to provide a light emitting device which is capable of improving the light extraction efficiency of the electroluminescence device by enabling the device to emit white light by using the electroluminescence device emitting a monochromatic light.

In order to achieve the above described object, an embodiment of the invention provides a light emitting device comprising a substrate having an incident surface and a light emitting surface opposite to the incident surface, an electroluminescence device for emitting light having a peak at a wavelength of no more than 490 nm, an optical resonant structure for enhancing light having a resonant wavelength among the light emitted from the electroluminescent device and a fluorescent layer for converting the light emitted from the substrate into white light, characterized by said electroluminescence device formed on the incident surface side of the substrate, said optical resonant structure formed on the incident surface side of the substrate side and said resonant structure formed on the light emitting surface side of the substrate.

The invention, together with objects and advantages thereof, may best be understood by reference to the following description of the presently preferred embodiments together with the accompanying drawings in which:
FIG. 1(a) schematically shows a structure according to a first embodiment of the invention;
FIG. 1(b) illustrates the operation of the structure of FIG. 1(a);
FIG. 2 (a) schematically shows a structure according to a second embodiment of the invention;
FIG. 2(b) illustrates the operation of the structure of FIG. 1(b);
FIGS. 3(a) and 3(b) show partial views of further embodiments;
FIG. 4 shows a partial view of still another embodiment; and
FIG. 5 shows a partial view of yet another embodiment.

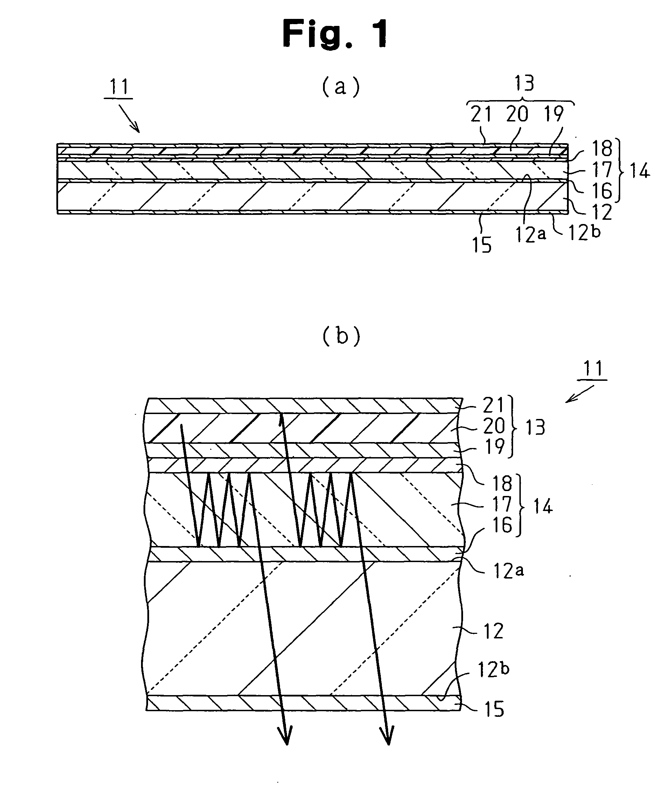

Referring FIGS. 1 (a) and 1 (b) , a first embodiment of the invention applied to a bottom emission type light emitting device using an organic electroluminescence device is described below. FIG. 1 (a) schematically shows the light emitting device and FIG. 1(b) is a partial enlarged view for illustrating operation of the device.

The electroluminescence device emits blue to ultraviolet light having a peak of wavelength at no more than 490 nm. Through the function of the optical resonant structure, the intensity of the light emitted from the electroluminescence device is enhanced at the resonant wavelength as well as the directivity of the light being improved. The light then enters into the substrate. The light is converted into white light during transmission through a fluorescent layer disposed at the light emitting surface side of the substrate and exits the light emitting device. The light emitting device is therefore a bottom emission type which is capable of emitting white light by means of the electroluminescence device emitting a monochromatic light and improves light extraction efficiency in the electroluminescence device.

The light emitting device 11 has on the light emitting surface 12a side of the substrate 12 an organic electroluminescence device 13 and a microcavity structure 14 used for the optical resonant structure enhancing the light of resonant wavelength. The device 11 includes on the light emitting surface 12b side the fluorescent layer 15 which converts the light exit from the substrate 12 into white light.

The substrate 12 is formed from a material having translucency with respect to light having a wavelength of no more then 490 nm, such as a glass plate for example. In the first embodiment a microcavity structure 14 is formed on the incident surface 12a of the substrate 12 and an organic electroluminescence device 13 is formed on the microcavity structure 14.

The microcavity structure 14 comprises a half mirror 16, a buffer layer 17 and a half mirror 18 formed in this order on the substrate 12. The half mirrors 16 and 18 are formed from a metal such as aluminum into a thickness ranging between 5 nm and 30 nm so that translucency with respect to the light is provided. The buffer layer 17 is formed from a translucent material and has a thickness corresponding to the optical path length, in an integral multiple of λ/ (2n) . In the formula, λ denotes the resonant wavelength. The wavelength can take a prescribed range (for example 30 nm) shorter than the peak wavelength of the light emitted from the organic electroluminescence device 13. In the formula, n denotes the refraction index of the material that forms the buffer layer.

The organic EL device 13 is formed into a lamination of a first electrode 19, an organic EL layer 20 and a second electrode 21 in this order over the microcavity structure 14. In the first embodiment the first electrode 19 forms the anode and the second electrode 21 forms the cathode.

The first electrode 19 comprises any material such as indium-tin oxide (ITO) or indium-zinc oxide (IZO) that are used as a transparent electrode in known organic EL devices. The second electrode 21 comprises a metal (aluminum, for example) and is provided with light reflecting properties. The material for forming the electrode having light reflecting properties is not limited to aluminum and other metals such as chromium can also be used. Note, however, that the reflectivity is lower in the case where chromium is used than the case of using aluminum.

The organic EL layer 20 can be formed from a material which emits blue to ultraviolet light having a peak wavelength at no more than 490 nm and which is used in known organic EL devices. The layer can be produced into a known structure through any known method. In the first embodiment the organic EL layer 20 is formed by laminating three layers, a hole injection layer, a hole transport layer and an emitting layer in this order on the first electrode 19. The emitting layer is formed into a film of a thickness of 30 nm as a doped emitter consisting of 4, 4-Bis (2, 2-diphenyl-ethen-1-yl) -biphenyl (DPVBi) as the host and 4,4'-(Bis(9-ethyl-3-carbazovinylene)-1,1'-biphenyl (BCzVBi) as the dopant. BCzVBi is contained in the film at 5.0% per weight with respect to DPVBi. The hole injection layer comprises copper phthalocyanine (CuPc) and is formed into a layer having a thickness of 10 nm in the first embodiment. The hole transport layer is formed into a film of a thickness of 10 nm comprising triphenylamine tetramer (TPTE) which has a methyl group at the metha-position of terminal phenyl.

The organic EL device 13 is covered with a passivation film (not shown in the figures) so that the organic EL layer 20 will not be in contact with the ambient atmosphere. The passivation film is formed to cover the side edges of the half mirror 16, the buffer layer 17, the half mirror 18, the first electrode 19, the organic EL layer 20 and the second electrode 21, and the surface of the second electrode 21 that is opposite to the surface of the second electrode 21 facing the organic EL layer 20. The passivation film is formed from any material which prevents permeation of moisture, such as silicon nitride and silicon oxide.

The fluorescent layer 15 functions to convert the light that exits the substrate 12 into white light. The materials of the fluorescent layer 15 include, for example, YAG (yttrium aluminum garnet) fluorescent material.

The operation of the light emitting device 11 as described above is provided next. The light emitting device 11 can be used as a backlight, for example, in a liquid crystal display device.

When the light emitting device 11 is powered on, a direct-current voltage is applied between the first electrode 19 and the second electrode 21 so that the organic El layer 20 emits blue light. As shown in FIG. 1 (b) , the light rays emitted from the organic EL layer 20 include those directly transmitted from the first electrode 19 and that pass toward the microcavity structure 14 and those that are reflected at the second electrode 21, towards the first electrode 19 and then move towards the microcavity structure 14.

Since the distance between the half mirrors 16 and 18 are set at an integer multiple of λ/(2n) wherein the resonant wavelength is λ the blue light that enters into the microcavity structure 14 is resonated between the half mirrors 16 and 18 as shown in FIG. 1(b). The intensity of the blue light is enhanced at the resonant wavelength λ. After the directivity is enhanced in the direction perpendicular to the light emitting surface 12b, the light exits from the light emitting surface 12b by passing through the fluorescent layer 15. The blue light is converted into white color light during transmission through the fluorescent layer 15 to emit white light from the light emitting device 11.

In a liquid crystal display device, the white light emitted from the light emitting device 11 is converted and displayed in desired colors by way of a three colored color filter of red (R), green (G) and blue (B), which is provided in the liquid crystal panel.

In the first embodiment, the light emitting device 11 has the electroluminescence device emitting light having a wavelength peak at no more than 490 nm, and the microcavity structure 14, which enhances the light of resonant wavelength, is on the incident surface 12a side of the translucent substrate 12. The device 11 has the fluorescent layer 15, which converts the light exiting from the light emitting surface 12b side of the substrate 12. Accordingly, monochromatic light emitted from the EL device can pass through the substrate without being scattered in the fluorescent layer 15 so that the light extraction efficiency of the EL device can be improved. Since the light that passed through the substrate is converted to white light at the fluorescent layer 15, white light can be obtained from the monochromatic light.

The necessary voltage for light emission can be suppressed in the first embodiment compared to the case where an inorganic EL device is used because the EL device is an organic EL device 13. Further, it is easier to obtain an electroluminescent material for emitting light having its peak wavelength at no more than 490 nm (blue or ultraviolet light).

In the first embodiment, the microcavity structure 14 is disposed closer to the substrate 12 than the organic EL device 13 is so that the organic EL device 13 can reflect the light emitted from the organic EL layer 20 in directions opposite to the substrate. Accordingly, the light emitted from the organic EL device 13 can exit from the light emitting surface 12b with greater efficiency compared to a structure in which the organic EL device 13 is disposed between the microcavity structure 14 and the substrate 12.

Since the microcavity structure 14 is disposed independently from the organic EL device 13 in the first embodiment, it is easier to set the optical path of the microcavity structure 14 at any desirable value.

The microcavity structure 14 of the first embodiment can be formed into a simple structure in which the microcavity structure 14 is formed from the half mirrors 16 and 18 and the buffer layer 17 in which the thickness of the buffer layer 17 is adjusted to a predetermined optical path.

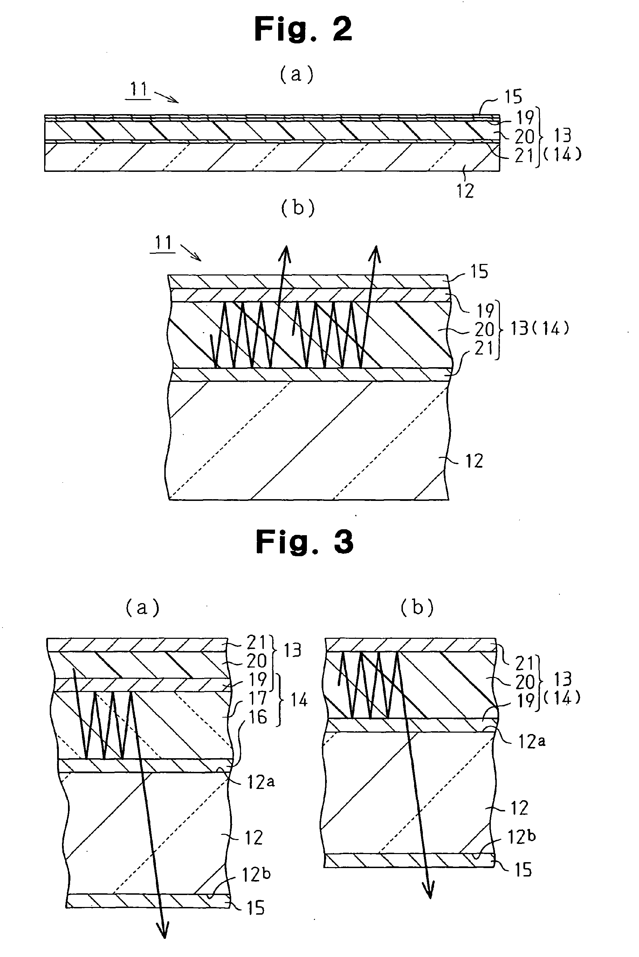

A second embodiment shown in FIG. 2 is next described. This structure differs from the first embodiment in that the light emitting device is formed into a top emission type device in which light emitted from the organic EL device 13 exits toward in direction opposite to the substrate. Further, the second embodiment is distinguishable from the first embodiment in that the organic EL device 13 forms the microcavity structure 14 instead of providing the organic EL device 13 and the microcavity structure 14 independently. Also in the second embodiment, the electroluminescence device emits blue to ultraviolet light having a peak wavelength at no more than 490 nm.

The intensity of the light emitted from the electroluminescence device is enhanced at the resonant wavelength as well as the directivity of the light is enhanced. The light then exits toward the opposite side to the substrate. The light is converted to white light during transmission through the electroluminescence device and through the fluorescent layer disposed on the outside of the optical resonant structure and exits the light emitting device. Accordingly, the light emitting device is a top emission type. The device is capable of emitting white light by means of a monochrome light electroluminescence device. The light extraction efficiency is improved in the electroluminescence device.

The second embodiment is described in more detail below. The light emitting device 11 is provided with the organic EL device 13 emitting light having a wavelength peak at no more than 490 nm, on one side of the substrate 12. The organic EL device 13 is formed from a lamination of the second electrode 21, the organic EL layer 20 and the first electrode 19 in this order on the substrate 12. The organic EL layer 20 and the second electrode 21 are formed from materials similar to those described with respect to the first embodiment. The first electrode 19 is formed from a metal having a thickness ranging from 5 nm to 30 nm to provide optical translucency to form a half mirror instead of forming it from a materials used for a transparent electrode, such as ITO. The organic EL layer 20 is formed to have a thickness corresponding to the optical path of an integral multiple of λ/(2n). Namely, the organic EL device 13 itself forms the microcavity structure 14 which enhances light of resonant wavelength.

The organic EL device 13 is covered by the passivation film (not shown in the figures) to avoid exposure of the organic EL layer 20 to the ambient atmosphere. The fluorescent layer 15 is laminated over the first electrode 19 by interposing the passivation film.

In the light emitting device 11 of the second embodiment, the direct-current voltage is applied between the first electrode 19 and the second electrode 21 when the device is powered on so that the organic EL layer 20 emits blue light. The organic EL layer 20 is interposed between the first electrode 19 formed as a half mirror and the light reflective second electrode 21 with a thickness of an integral multiple of λ/ (2n) . Accordingly the light emitted from the organic EL layer 20 is resonated between the first electrode 19 and the second electrode 21 as shown in FIG. 2(b). The intensity of the blue light having the resonant wavelength λ is then enhanced. After the directivity of the light is enhanced in the direction perpendicular to the fluorescent layer 15, the light exits through the fluorescent layer 15. The blue light is converted to white during transmission through the fluorescent layer 15 so that the light emitting device 11 emits white light.

In the second embodiment, the fluorescent layer 15 is disposed on the outside of the EL device and the microcavity structure 14 so that light can be color converted to white after enhancing the intensity of the resonant wavelength by means of the microcavity structure 14. Accordingly, the light emitting device 11 of the second embodiment can emit white light by using the EL device, which emits monochrome light from the top emission structure. In this structure, the light exits on the opposite side of the substrate. The light extraction efficiency is also improved.

Since the EL device (organic EL device 13) itself forms the microcavity structure 14, at least a part of the optical resonant structure and a part of the electroluminescence device can be shared. Accordingly, the structure can be simpler than the case where the microcavity structure 14 is disposed independently from the organic EL device. It is also possible to form the entire device thinner compared to the independently formed organic EL device and microcavity structure.

Since the light emitting device 11 is a top emission type which emits light toward opposite side of the substrate, the light emitted from the organic EL device 13 does not transmit through the substrate 12. Accordingly, the amount of light emitted will not be decreased due to absorption during transmission through the substrate 12.

The substrate 12 need not have translucency. Accordingly, the material for the substrate 12 can be selected from among a wider range of materials.

It should be apparent to those skilled in the art that the present invention may be embodied in many other specific forms without departing from the spirit or scope of the invention. Particularly, it should be understood that the invention may be embodied in the following forms.

Instead of forming the organic EL device 13 itself to also function as the microcavity structure 14, the organic EL device 13 can be formed to function as a part of the microcavity structure 14. In a bottom emission type light emitting device 11 for example, as shown in FIG. 3(a), the half mirror 18 can be omitted and the first electrode 19 can be formed as a half mirror. In this structure, the light emitted from the organic EL layer 20 is resonated between the half mirror 16 and the first electrode 19 to enhance the directivity and the intensity at the resonant wavelength λ. The light then exits the device after passing through the substrate 12 and the fluorescent layer 15. The light emitting device 11 can be formed thinner compared to the case of the first embodiment by omitting the half mirror 18.

In a bottom emission type light emitting device 11, the first electrode 19 shown in FIG. 3(a) can be formed as a transparent electrode instead of forming it as a half mirror and setting the total thickness, namely the optical path of the buffer layer 17, the first electrode 19 and the organic EL layer 20, to an integral multiple of λ/ (2n) . In this case, the light emitted from the organic EL layer 20 is resonated between the half mirror 16 and the light reflective second electrode 21 to enhance the intensity at the resonant wavelength λ and the directivity in the direction perpendicular to the light emitting surface 12b. The light then exits the device after passing through the substrate 12 and the fluorescent layer 15.

A bottom emission type light emitting device 11 can be formed to provide the function of the microcavity structure 14 by the organic EL device 13 itself as described in the second embodiment. That is, the organic EL device 13 is formed on the incident surface 12a and the first electrode 19 is formed as a half mirror from a metal having translucency and a thickness of between 5 nm and 30 nm instead of forming the electrode from the materials used for a transparent electrode, such as ITO. The organic EL layer 20 is formed into the appropriate thickness, namely, an optical path length corresponding to an integral multiple of λ/ (2n) . The second electrode 21 comprises a light reflecting metal. The organic EL device 13 is covered by a passivation film (not shown in the figures) to avoid exposure of the organic EL layer 20 to the ambient atmosphere. In this structure, the light emitted from the organic EL layer 20 is resonated between the first electrode 19 formed as a half mirror and the light reflecting second electrode 21 to enhance the intensity at the resonant wavelength λ and directivity toward the direction perpendicular to the light emitting surface 12b. The light then exits the device through the substrate 12 and the fluorescent layer 15. In this case, compared to the first embodiment, the light emitting device 11 can be formed thinner, not only by the thickness of the half mirror 18, but also by the total thickness of the half mirror 16 and the organic EL layer 20 of the first embodiment. The structure of the light emitting device can be also simpler.

The microcavity structure 14 can be formed from a combination of the organic EL device 13 and an insulator mirror disposed between the first electrode 19 and the substrate 12. The insulator mirror is formed, for example, from an alternative lamination of TiO₂ layers and SiO₂ layers.

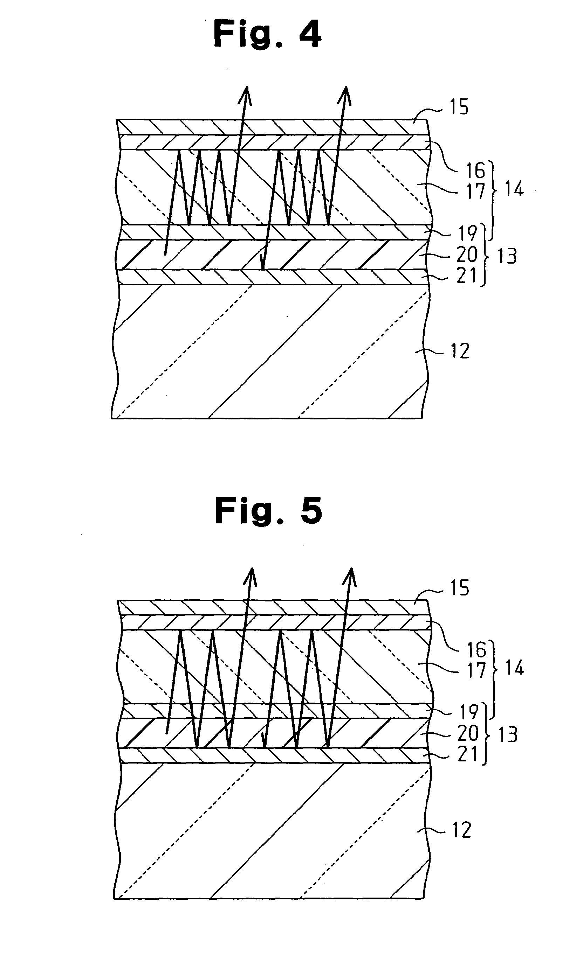

The top emission type light emitting device 11 can also be formed, similarly to the bottom emission type, to provide the organic EL device 13 and the microcavity structure 14 independently, or to share a portion of the organic EL device 13 with a portion of the microcavity structure 14. For example, as shown in FIG. 4, an organic EL device 13 emitting light having a peak wavelength at no more than 490 nm and a microcavity that enhances the resonant wavelength disposed in this order from the substrate 12. The second electrode 21 having light reflecting properties is disposed on the side next to the substrate 12. The half mirror 18 of the microcavity structure 14 is omitted and the first electrode 19 disposed opposite to the buffer layer 17 of the microcavity structure 14 is formed into a half mirror. In this structure, the light emitted from the organic EL layer 20 is resonated between the half mirror 16 and the second electrode 21. The intensity and directivity of are enhanced at the resonant wavelength λ and then the light exits through the fluorescent layer 15.

It is also possible to omit the half mirror 18 of the microcavity structure 14 and form the first electrode 19 from a transparent electrode as shown in FIG. 5 to provide resonance between the half mirror 16 and the second electrode 21.

In the case of independently providing the organic EL device 13 and the microcavity structure 14 in the bottom emission type light emitting device 11, the organic EL device 13 can be formed between the substrate 12 and the microcavity structure 14. However, as already described in the first embodiment, the light emitted from the organic EL device 13 can exit from the light emitting surface 12b with greater efficiency when the microcavity structure 14 is formed between the substrate 12 and the organic EL device 13.

The optical path between the half mirrors 16 and 18 can be set at an odd number multiple of λ/(4n) without being constrained to the integral multiple of λ/ (2n) . Further, the distance between the first electrode 19 and the second electrode 21, the distance between the half mirror 16 and the first electrode 19 or the distance between the half mirror 16 and the second electrode 21 can also be formed at an odd number multiple of λ/(4n) in cases where the organic EL device 13 itself forms the microcavity structure 14 or the organic EL device 13 forms a portion of the microcavity structure 14.

The emitting layer which emits blue light is not limited to the doped emitter consisting of DPVBi as the host and BCzVBi as the dopant. Other examples are aryl ethynil benzene derivative where the aryl group is fluoren, beryllium complex having 1m3m5-oxadiazol based oxydiazol ligands or perylene. It is also possible to use tri(o-terphenyl-4-yl)amine or tri(p-terphenyl-4-yl)amine as a hole transport emitting layer and laminating an electron transfer emitting layer of 5,5'-tris(3-methyl phenyl phenylamino)triphenyl amine thereon.

The first electrode 19 can be a cathode and the second electrode 21 can be an anode. In this case, the structure of the organic EL layer 20 is also altered to correspond to this structure. For example, the organic EL layer 20 can be formed into a three-layered structure comprising the electron injection layer, the emitting layer and the hole injection layer in this order from the first electrode 19, or can be formed into a five layered structure comprising the electron injection layer, the electron transport layer, emitting layer, the hole transport layer and the hole injection layer in this order from the first electrode 19.

The organic EL layer 20 can be formed from a single layer from the emitting layer, or can be formed from a lamination of layers of the emitting layer and one selected from the hole injection layer, the hole transport layer, the hole injection transport layer, the hole blocking layer, the electron injection layer, the electron transport layer and the electron blocking layer.

The application of the light emitting device 11 is not limited to backlighting. It can also be used as a light source for other illuminating devices or display devices.

Instead of using the organic EL device 13, an inorganic EL device can also be used as the EL device. However, the organic EL device 13 is preferable because the applied voltage during emitting of light is lower in the organic EL device 13 compared to inorganic EL devices.

A transparent substrate comprising resin or a flexible transparent resin substrate can be used for the substrate 12 in place of the glass substrate. The weight can be reduced when resin is used compared to devices using a glass substrate.

Therefore, the present examples and embodiments are to be considered as illustrative and not restrictive and the invention is not to be limited to the details given herein, but may be modified within the scope and equivalence of the appended claims.

A light emitting device has an electroluminescence device, an optical resonant structure and a fluorescent layer disposed over a substrate. The substrate has an incident surface and a light emitting surface opposite to the incident surface. The electroluminescence device is formed on the incident surface side of the substrate, for emitting light having a peak at a wavelength of no more than 490 nm. The optical resonant structure is formed on the incident surface side of the substrate side, for enhancing light having a resonant wavelength among the light emitted from the electroluminescent device. The fluorescent layer is formed on the light emitting surface side of the substrate, for converting the light emitted from the substrate into white light.

## Claims

1. A light emitting device comprising a substrate having an incident surface and a light emitting surface opposite to the incident surface, an electroluminescence device for emitting light having a peak at a wavelength of no more than 490 nm, an optical resonant structure for enhancing light having a resonant wavelength among the light emitted from the electroluminescent device and a fluorescent layer for converting the light emitted from the substrate into white light, **characterized by** said electroluminescence device formed on the incident surface side of the substrate, said optical resonant structure formed on the incident surface side of the substrate side and said resonant structure formed on the light emitting surface side of the substrate.

2. The light emitting device according to claim 1 **characterized by** the electroluminescence device forming the optical resonant structure.

3. The light emitting device according to claim 1 or 2 **characterized by** the electroluminescence device being an organic electroluminescence device.

4. The light emitting device according to any one of claims 1 to 3 **characterized by** the optical resonant structure including a pair of half mirrors and a buffer layer and the light having the resonant wavelength resonated between the pair of half mirrors.

5. The light emitting device according to claim 4 **characterized by** the distance between the half mirrors set at an integral multiple of λ/ (2n) , wherein λ denotes the resonant wavelength and n denotes the refraction index of the material forming the buffer layer.

6. The light emitting device according to claim 4 **characterized by** the distance between the half mirrors set at a odd number integer multiple of λ/ (4n) , wherein λ denotes the resonant wavelength and n denotes the refraction index of the material forming the buffer layer.

7. The light emitting device according to any one of claims 1 to 6 **characterized by** the electroluminescence device having a first electrode, a second electrode and an electroluminescence layer interposed between the first and second electrodes, the second electrode having a light reflecting property.

8. The light emitting device according to claim 7 **characterized by** the first electrode functioning as one of the pair of half mirrors of the optical resonant structure.

9. The light emitting device according to any one of claims 1 and 3 to 8 **characterized by** the optical resonant structure formed between the substrate and the electroluminescence device.

10. A light emitting device comprising a substrate, an electroluminescence device formed on one side of the substrate for emitting light having a peak at a wavelength of no more than 490 nm, an optical resonant structure formed on said one side of the substrate for enhancing light having a resonant wavelength among the light emitted from the electroluminescent device and a fluorescent layer formed on said one side of the substrate for converting the light emitted from the substrate into white light, **characterized by** the optical resonant structure disposed between the substrate and the fluorescent layer.

11. The light emitting device according to claim 10 **characterized by** the electroluminescence device forming the optical resonant structure.

12. The light emitting device according to claim 10 or 11 **characterized by** the electroluminescence device is an organic electroluminescence device.

13. The light emitting device according to any one of claims 10 to 12 **characterized by** the optical resonant structure having a pair of half mirrors and a buffer layer and wherein the light having the resonant wavelength is resonated between the pair of half mirrors.

14. The light emitting device according to claim 13 **characterized by** the distance between the half mirrors set at an integral multiple of λ/ (2n) , wherein λ denotes the resonant wavelength and n denotes the refraction index of the material forming the buffer layer.

15. The light emitting device according to claim 13 **characterized by** the distance between the half mirrors set at an odd number integer multiple of λ/ (4n) , wherein λ denotes the resonant wavelength and n denotes the refraction index of the material forming the buffer layer.

16. The light emitting device according to any one of claims 10 to 15 **characterized by** the electroluminescence device having a first electrode, a second electrode and an electroluminescence layer interposed between the first and second electrodes, the second electrode having a light reflecting property.

17. The light emitting device according to claim 16 **characterized by** the first electrode functioning as one of the pair of half mirrors of the optical resonant structure.

18. The light emitting device according to any one of claims 10 and 12 to 17 **characterized by** the optical resonant structure formed between the substrate and the electroluminescence device.
